# EUROPÄISCHE PATENTSCHRIFT

(11) **EP 1 668 778 B1**
(45) Veröffentlichungstag und Bekanntmachung des Hinweises auf die Patenterteilung: **31.10.2007**
(21) Anmeldenummer: 04786878.1
(22) Anmeldetag: 29.09.2004
(51) Int. Cl.: H03L 7/081, H03K 5/13

(54) **VERZÖGERUNGSREGELKREIS**
DELAY CONTROL LOOP
CIRCUIT DE REGULATION DE TEMPORISATION

(30) Priorität: 29.09.2003 DE 10345236
(43) Veröffentlichungstag der Anmeldung: 14.06.2006
(73) Patentinhaber: Infineon Technologies AG, 81669 München (DE)
(72) Erfinder: MINZONI, Alessandro, Xi'an High-Tech Industri, 710075 Xi'an (CN)
(74) Vertreter: Epping - Hermann - Fischer
(86) Internationale Anmeldenummer: PCT/DE2004/002166
(87) Internationale Veröffentlichungsnummer: WO 2005/031979

(56) Entgegenhaltungen:
- US-B1- 6 292 040

## Beschreibung

Die vorliegende Erfindung betrifft einen Verzögerungsregelkreis, bei dem eine Verzögerungseinrichtung mit steuerbarer Verzögerungszeit zwischen einen Eingangsanschluß für ein zu verzögerndes Eingangstaktsignal und einen Ausgangsanschluß zum Abgriff eines verzögerten Ausgangstaktsignals geschaltet ist. Die Verzögerungszeit wird in Abhängigkeit von einer Phasendifferenz zwischen dem Eingangstaktsignal und Ausgangstaktsignal eingestellt.

Verzögerungsregelkreise sind beispielsweise in taktgesteuerten integrierten Schaltungen vorgesehen, um ein Ausgangstaktsignal des Verzögerungsregelkreises hinsichtlich der Phasendifferenz in Bezug auf ein Eingangstaktsignal einzustellen. Verzögerungsregelkreise finden insbesondere in synchron betriebenen dynamischen Halbleiterspeichern Anwendung, hier vor allem bei sogenannten DDR SDRAMs (Double Data Rate Synchronous Dynamic Random Access Memories) und werden auch als Delay Locked Loop (DLL) bezeichnet. Mit Hilfe eines Verzögerungsregelkreises wird ein eingangsseitig zugeführtes Taktsignal mittels eines Regelkreises derart verzögert, daß ein ausgangsseitiges Taktsignal eine vorgegebene Phasenlage aufweist.

Ein Verzögerungsregelkreis oder eine DLL-Schaltung wird bei DDR SDRAMs verwendet, um zu schreibende oder auszulesende Datensignale synchron zu einem eingangsseitig zugeführten Taktsignal bereitzustellen, und zwar sowohl an der steigenden als auch an der fallenden Flanke dieses Taktsignals. Der Phasenregelkreis berücksichtigt die internen Signallaufzeiten des zugeführten Taktes und insbesondere eine Zeitverzögerung in Empfängerschaltungen zum Empfang von Signalen und eine Zeitverzögerung in Ausgangstreibern zur Bereitstellung von Ausgangssignalen. Beim Auslesen von Datensignalen aus dem Speicher wird durch die DLL-Schaltung der Ausgangstreiber mit einem entsprechend eingestellten, gegenüber dem Eingangstaktsignal verzögerten Taktsignal versorgt, um die zu treibenden Ausgangsdaten synchron mit dem am externen Datenbus vorliegenden Taktsignal abzugeben.

Um den DDR SDRAM in einem großen Betriebsfrequenzbereich betreiben zu können, ist es erforderlich, daß die DLL-Schaltung in einem großen Betriebsfrequenzbereich betreibbar ist, der insbesondere flexibel variierbar sein sollte. Eine niedrige Betriebsfrequenz erfordert eine lange steuerbare Verzögerungszeit der im Regelkreis enthaltenen Verzögerungseinrichtung, wozu im allgemeinen eine vergleichsweise lange Verzögerungskette zur Verzögerung um mehr als eine Taktperiode notwendig ist. Andererseits wird in Bezug auf hohe Betriebsfrequenzen eine hohe Auflösung der Verzögerungskette gefordert, um auch bei hohen Betriebsfrequenzen eine möglichst gute Justierung von Ausgangstaktsignal zu Eingangstaktsignal zu erreichen.

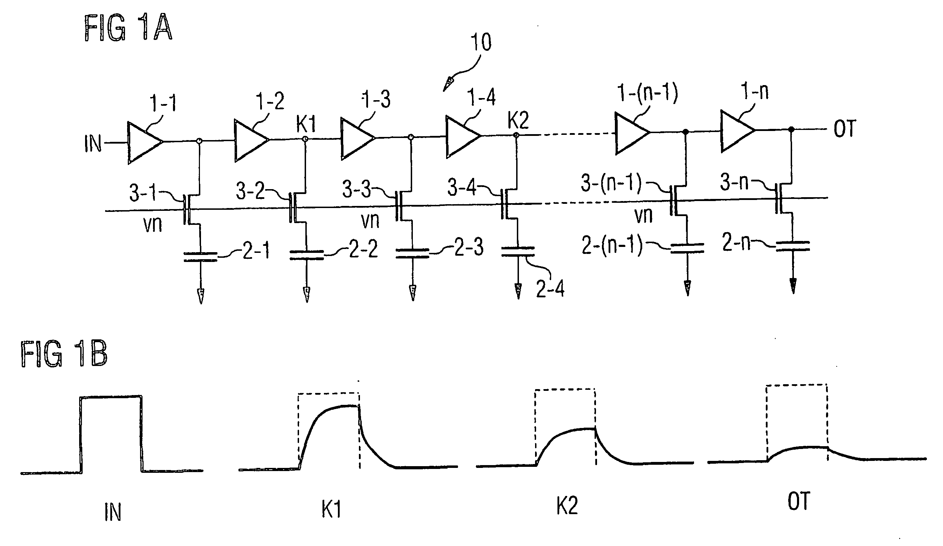

Bei hohen Taktsignalfrequenzen, insbesondere bei Frequenzen größer als 500 MHz, tritt weiterhin das Problem auf, daß die Signalform eines Ausgangstaktsignals in Bezug auf die Signalform des Eingangstaktsignals durch die Verzögerungskette in der Verzögerungseinrichtung einer DLL-Schaltung verändert werden kann. In Figur 1 ist eine Ausführungsform einer bekannten Verzögerungskette eines Verzögerungsregelkreises mit einem zugehörigen Signaldiagramm eines zu verzögernden Eingangstaktsignals an verschiedenen Stellen der Verzögerungskette gezeigt. Die Verzögerungskette 10 gemäß Figur 1A weist in Reihe geschaltete Inverterstufen 1-1 bis 1-n auf, wobei am Eingangsanschluß IN der Inverterstufe 1-1 ein Eingangstaktsignal mit rechteckförmigem Signalverlauf anliegt. Zwischen den Inverterstufen 1-1 bis 1-n ist am jeweiligen Verbindungsknoten jeweils eine Kapazität 2-1 bis 2-n über jeweilige Schalttransistoren 3-1 bis 3-n angeschlossen. Hierbei sind die Transistoren 3-1 bis 3-n von einer Steuerspannung vn steuerbar. Ein Ausgangstaktsignal ist am Ausgangsanschluß OT der Inverterstufe 1-n entnehmbar. Die derart aufgebaute Verzögerungskette 10 zeigt gegenüber einem Eingangstaktsignal mit hoher Frequenz ein Tiefpass-Verhalten, so daß das Taktsignal an den Verbindungsknoten K1 und K2 sowie am Ausgangsanschluß OT den in Figur 1B gezeigten Signalverlauf aufweist. Durch eine derartige Veränderung des Signalverlaufs des Eingangstaktsignals am Ausgangsanschluß OT ist es kaum noch möglich, bei hohen Frequenzen eines Eingangstaktsignals ein geeignetes Ausgangstaktsignal am Ausgang einer DLL-Schaltung zu erzeugen.

Die Druckschrift US 2002/0027967 A1 beschreibt einen Verzögerungsregelkreis (Delay Locked-Loop), der einen Phasendetektor zur Detektion einer Phasendifferenz zwischen einem externen Taktsignal und einem internen Taktsignal, eine Steuereinheit und eine variable Verzögerungseinheit umfaßt. In Abhängigkeit von der von dem Phasendetektor detektierten Phasendifferenz zwischen dem externen Taktsignal und dem internen Taktsignal steuert die Steuerschaltung die variable Verzögerungseinheit in der Weise, dass das interne Taktsignal mit dem externen Taktsignal synchronisiert ist. Die variable Verzögerungseinheit umfaßt eine erste Gruppe von Verzögerungszellen, die über steuerbare Schalter mit einer ersten Ausgangsleitung verbindbar sind, sowie zweite Verzögerungszellen, die über weitere steuerbare Schalter mit einer zweiten Ausgangsleitung verbindbar sind. Die Verzögerungszellen werden von dem externen Taktsignal angesteuert. Im Falle eines hochfrequenten externen Taktsignals werden Verzögerungszellen der ersten Gruppe aktiviert und mit der ersten Ausgangsleitung verbunden. Im Falle eines niederfrequenten externen Taktsignals werden die Verzögerungszellen der ersten Gruppe zusammen mit den Verzögerungszellen der zweiten Gruppe aktiviert und die erste Ausgangsleitung zur Erzeugung des internen Taktsignals über einen steuerbaren Schalter mit der zweiten Ausgangsleitung verbunden. Da im hochfrequenten Betriebsfall die zweite Ausgangsleitung von der ersten Ausgangsleitung durch den steuerbaren Schalter getrennt ist, wird die Last der zweiten Ausgangsleitung reduziert. Dadurch kann ein stabiler Betrieb des Verzögerungsregelkreises bei einer Ansteuerung mit einem hochfrequenten externen Taktsignal gewährleistet werden.

Die Druckschrift DE 100 65 376 C1 beschreibt eine Verzögerungsschaltung mit einstellbarer Verzögerung. Die Verzögerungsschaltung umfaßt einen ersten Block und ein nachgeschalteten zweiten Block, welche jeweils eine Kette von Verzögerungsgliedern aufweisen. Jedem Block ist eine Schaltergruppe zugeordnet, mit denen ausgangsseitige Abgriffe an den Verzögerungsgliedern mittels Schaltern auswählbar sind, um eine gewünschte Verzögerungszeit auswählen zu können. Zur gleichzeitigen Ansteuerung des am ausgangsseitigen Verzögerungsgliedes des ersten Blocks angeschlossenen Schalters und des am eingangsseitigen Verzögerungsglied des zweiten Blocks angeschlossenen Schalters sind deren Steuereingänge miteinander verbunden. Hierdurch können Störimpulse auch bei hohen Taktraten von eingangsseitig an den Verzögerungsgliedern anlegbaren Taktsignalen vermieden werden. Die beschriebene Verzögerungsschaltung ist deshalb besonders zur Anwendung in Verzögerungsregelschleifen in DDR-Speicherchips geeignet.

Die US 6 292 040 zeigt einen Verzögerungsregelkreis gemäß dem Oberbegriff von Anspruch 1.

Der vorliegenden Erfindung liegt die Aufgabe zugrunde, einen Verzögerungsregelkreis der eingangs genannten Art anzugeben, der in einem breiten Betriebsfrequenzbereich betreibbar ist und auch bei hohen Betriebsfrequenzen ein geeignetes Ausgangstaktsignal bereitstellt.

Diese Aufgabe wird gemäß der Erfindung durch einen Verzögerungsregelkreis nach Patentanspruch 1 gelöst.

Der Verzögerungsregelkreis nach der Erfindung weist eine Verzögerungseinrichtung mit steuerbarer Verzögerungszeit auf, die in Reihe zwischen den Eingangsanschluß zum Empfang des zu verzögernden Eingangstaktsignal und den Ausgangsanschluß zum Abgriff eines verzögerten Ausgangstaktsignals geschaltet ist.

Die Verzögerungseinrichtung gemäß der Erfindung weist einen ersten Schaltungsteil, einen dem ersten Schaltungsteil nachgeschalteten zweiten Schaltungsteil und einen dem zweiten Schaltungsteil nachgeschalteten dritten Schaltungsteil auf. Weiterhin ist eine Steuerungseinrichtung zur Bereitstellung eines der Verzögerungseinrichtung zuführbaren Steuersignals in Abhängigkeit von einer Phasendifferenz zwischen dem zu verzögernden und dem verzögerten Taktsignal vorgesehen. Der erste Schaltungsteil empfängt das Eingangstaktsignal, reduziert eine Frequenz des Eingangstaktsignals und gibt ein Taktsignal mit reduzierter Frequenz an den zweiten Schaltungsteil aus. Dieser leitet das Taktsignal mit reduzierter Frequenz mit steuerbarer Verzögerungszeit verzögert an den dritten Schaltungsteil weiter. Der dritte Schaltungsteil erzeugt aus dem verzögerten Taktsignal mit reduzierter Frequenz das Ausgangstaktsignal, welches die Frequenz des Eingangstaktsignals aufweist.

Gemäß der Erfindung wird also in der Verzögerungseinrichtung des Verzögerungsregelkreises das zu verzögernde Eingangstaktsignal in seiner Frequenz reduziert. Das niederfrequente Taktsignal wird in dem zweiten Schaltungsteil insbesondere einer Verzögerungskette zugeführt, die in ihrer Verzögerungszeit steuerbar ist. Aus dem in der Verzögerungskette verzögerten Taktsignal mit reduzierter Frequenz wird im dritten Schaltungsteil das Ausgangstaktsignal rekonstruiert, welches wieder die Frequenz des Eingangstaktsignals aufweist. Da in der Verzögerungskette des zweiten Schaltungsteils ein Taktsignal mit reduzierter Frequenz verarbeitet wird, ist es ermöglicht, die anhand von Figur 1 einleitend beschriebenen Probleme bezüglich der Signalveränderung des Eingangstaktsignals zu vermeiden. Zugleich weist die Erfindung den weiteren Vorteil auf, daß für den zweiten Schaltungsteil eine Verzögerungskette herkömmlicher Art verwendet werden kann und der Verzögerungsregelkreis dennoch bei hohen Betriebsfrequenzen betrieben werden kann. Hierbei ist es vorteilhaft, daß der Wert der einzustellenden Verzögerungszeit im Verzögerungsregelkreis gegenüber der bisherigen Lösung unverändert belassen werden kann. Weiterhin kann auch der untere Betriebsfrequenzbereich beibehalten werden, so daß insgesamt der Verzögerungsregelkreis gemäß der Erfindung in einem weiten Betriebsfrequenzbereich betreibbar ist. Insbesondere ist es mit der Erfindung ermöglicht, eine Betriebsfrequenz eines Eingangstaktsignals von bis zu 1,4 GHz zu verarbeiten.

Gemäß einer bevorzugten Ausführungsform der Erfindung empfängt der Eingangsanschluß das zu verzögernde Eingangstaktsignal und ein dazu komplementäres Eingangstaktsignal. Der erste Schaltungsteil erzeugt aus dem Eingangstaktsignal das Taktsignal mit reduzierter Frequenz und aus dem komplementären Eingangstaktsignal ein Komplementär-Taktsignal mit reduzierter Frequenz. Der zweite Schaltungsteil weist zwei Verzögerungsketten auf, wobei eine der Verzögerungsketten das Taktsignal mit reduzierter Frequenz und die andere Verzögerungskette das Komplementär-Taktsignal mit reduzierter Frequenz jeweils mit steuerbarer Verzögerungszeit an den dritten Schaltungsteil weiterleitet. Der dritte Schaltungsteil erzeugt aus dem verzögerten Taktsignal und dem verzögerten Komplementär-Taktsignal mit reduzierter Frequenz das Ausgangstaktsignal.

In einer Weiterbildung ist der dritte Schaltungsteil derart ausgebildet, daß die steigenden Flanken des Ausgangstaktsignals aus den steigenden und fallenden Flanken des verzögerten Taktsignals mit reduzierter Frequenz erzeugt werden. Entsprechend werden die fallenden Flanken des Ausgangstaktsignals aus den steigenden und fallenden Flanken des verzögerten Komplementär-Taktsignals mit reduzierter Frequenz erzeugt. Hierbei ist es von besonderem Vorteil, wenn der zweite Schaltungsteil derart beschaffen ist, daß die Verzögerungszeiten in Bezug auf das Taktsignal mit reduzierter Frequenz und das Komplementär-Taktsignal mit reduzierter Frequenz näherungsweise gleich sind. Hierzu wird bevorzugt eine Verzögerungskette mit symmetrischem Schaltverhalten bezüglich steigender und fallender Flanken eines Taktsignals verwendet, so daß die steigenden und fallenden Flanken des Taktsignals mit reduzierter Frequenz und des Komplementär-Taktsignals mit reduzierter Frequenz näherungsweise gleich verzögert werden.

Weitere vorteilhafte Aus- und Weiterbildungen der Erfindung sind in Unteransprüchen angegeben.

Die Erfindung wird im folgenden anhand der in der Zeichnung dargestellten Figuren näher erläutert.
- Figur 1: zeigt eine Ausführungsform einer bekannten Verzögerungskette eines Verzögerungsregelkreises mit zugehörigem Signaldiagramm eines zu verzögernden Taktsignals an verschiedenen Stellen der Verzögerungskette, wie einleitend bereits beschrieben,
- Figur 2: zeigt eine Ausführungsform eines Verzögerungsregelkreises gemäß der Erfindung,
- Figur 3: zeigt eine Ausführungsform eines ersten Schaltungsteils einer Verzögerungseinrichtung des Verzögerungsregelkreises gemäß der Erfindung mit einem zugehörigen Signaldiagramm,
- Figuren 4 bis 7: zeigen Ausführungsformen von Verzögerungsketten für eine Verzögerungseinrichtung des Verzögerungsregelkreises gemäß der Erfindung,
- Figur 8: zeigt eine erste Ausführungsform eines dritten Schaltungsteils einer Verzögerungseinrichtung des Verzögerungsregelkreises gemäß der Erfindung mit einem zugehörigen Signaldiagramm,
- Figur 9: zeigt ein Signaldiagramm von Signalen einer Ausführungsform eines Verzögerungsregelkreises gemäß der Erfindung,
- Figur 10: zeigt eine zweite Ausführungsform eines dritten Schaltungsteils einer Verzögerungseinrichtung des Verzögerungsregelkreises gemäß der Erfindung,
- Figur 11: zeigt ein Signaldiagramm von Signalen einer weiteren Ausführungsform eines Verzögerungsregelkreises gemäß der Erfindung.

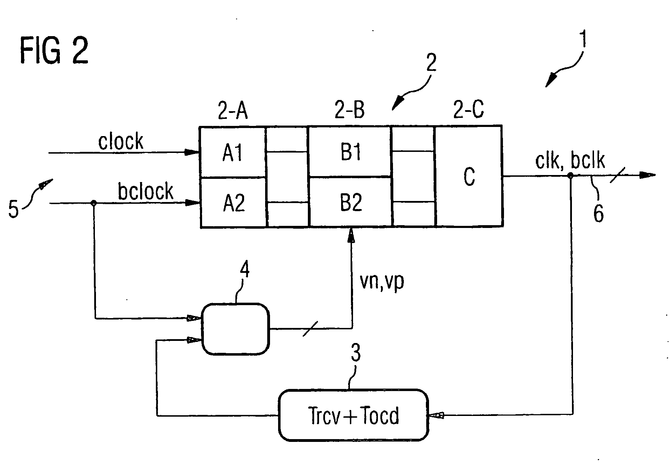

Figur 2 zeigt eine Ausführungsform eines Verzögerungsregelkreises gemäß der Erfindung. Der in Figur 2 dargestellte Verzögerungsregelkreis 1 weist einen Eingangsanschluß 5 auf, an dem ein zu verzögerndes Eingangstaktsignal clock zugeführt wird. Weiterhin wird in der Ausführungsform gemäß Figur 2 dem Eingangsanschluß 5 ein zum Eingangstaktsignal clock komplementäres Eingangstaktsignal bclock zugeführt. Über eine Verzögerungseinrichtung 2 wird ein gegenüber dem Eingangstaktsignal clock verzögertes Ausgangstaktsignal clk am Ausgangsanschluß 6 des Verzögerungsregelkreises bereitgestellt. Entsprechend wird ein zum komplementären Eingangstaktsignal bclock verzögertes komplementäres Ausgangstaktsignal bclk am Ausgangsanschluß 6 bereitgestellt. Das Ausgangstaktsignal clk bzw. das komplementäre Ausgangstaktsignal bclk wird über ein Verzögerungselement 3 mit konstanter Verzögerungszeit auf eine Steuerungseinrichtung 4 mit einem Phasendetektor rückgekoppelt. In dem Verzögerungselement 3 werden die Verzögerungszeiten Trcv von Signalempfängerschaltungen und Tocd von Ausgangstreiberschaltungen berücksichtigt. Der Phasendetektor vergleicht dieses rückgekoppelte Ausgangssignal hier mit dem komplementären Eingangstaktsignal bclock und gibt ein die Phasendifferenz repräsentierendes Steuersignal vn, vp an die Verzögerungseinrichtung 2 ab. Hierbei wird das Steuersignal vn, vp in Abhängigkeit von einer Phasendifferenz zwischen dem zu verzögernden Eingangstaktsignal clock bzw. bclock und dem verzögerten Ausgangstaktsignal clk bzw. bclk eingestellt. Auf diese Art sind Verzögerungszeiten in der Verzögerungseinrichtung 2 einstellbar. In Abhängigkeit von Größe und Vorzeichen der Phasendifferenz werden Verzögerungszeiten in der Verzögerungseinrichtung 2 entsprechend nachgestellt. Die Regelung ist darauf ausgelegt, daß die Phasendifferenz am Phasendetektor möglichst auf Null ausgeregelt wird.

Die Verzögerungseinrichtung 2 gemäß Figur 2 weist drei unterschiedliche Schaltungsteile 2-A, 2-B und 2-C auf, welche in der Figur 2 blockweise angedeutet sind und in ihrer Struktur im folgenden noch näher erläutert werden. Der erste Schaltungsteil 2-A ist seinerseits in zwei Schaltungsblöcke A1, A2 untergliedert, entsprechend der zweite Schaltungsteil 2-B in einzelne Schaltungsblöcke B1, B2. Hierbei ist der Schaltungsblock B1 dem Schaltungsblock A1 nachgeschaltet und der Schaltungsblock B2 dem Schaltungsblock A2 nachgeschaltet. Der dritte Schaltungsteil 2-C ist dem zweiten Schaltungsteil 2-B nachgeschaltet und weist den Schaltungsblock C auf. Der Schaltungsblock A1 des ersten Schaltungsteils 2-A empfängt das Eingangstaktsignal clock, der Schaltungsblock A2 des ersten Schaltungsteils 2-A empfängt das dazu komplementäre Eingangstaktsignal bclock. Der Schaltungsblock A1 erzeugt an seinem Ausgang aus dem Eingangstaktsignal clock ein Taktsignal mit reduzierter Frequenz, der Schaltungsblock A2 erzeugt an seinem Ausgang aus dem komplementären Eingangstaktsignal bclock ein Komplementär-Taktsignal mit reduzierter Frequenz. Diese werden durch die Schaltungsblöcke B1 bzw. B2 des zweiten Schaltungsteils 2-B jeweils mit steuerbarer Verzögerungszeit an den dritten Schaltungsteil 2-C weitergeleitet, dessen Schaltungsblock C aus dem verzögerten Taktsignal bzw. Komplementär-Taktsignal mit reduzierter Frequenz die Ausgangstaktsignale clk, bclk erzeugt, welche die Frequenz der Eingangstaktsignale clock bzw. bclock aufweisen.

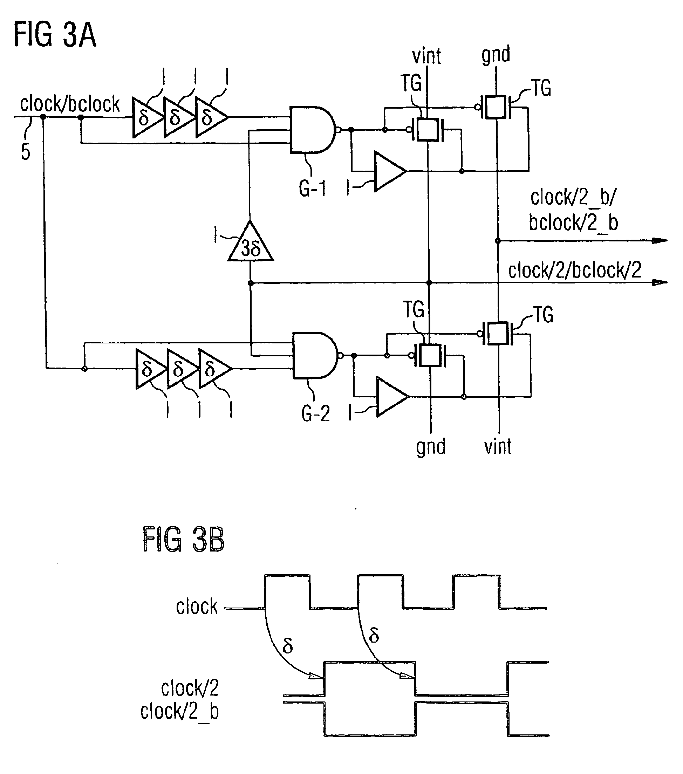

In Figur 3 ist eine Ausführungsform eines ersten Schaltungsteils bzw. dessen Schaltungsblöcke A1, A2 eines Verzögerungsregelkreises gemäß Figur 2 mit zugehörigem Signaldiagramm gezeigt. Die Schaltungsblöcke A1 und A2 sind dabei in gleicher Weise aufgebaut, wie anhand von Figur 3A dargestellt. Sie weisen jeweils eine Verschaltung aus Inverterstufen I mit einer jeweiligen Verzögerung δ, aus NAND-Gattern G-1, G-2 und aus Transfer-Gates TG in der in Figur 3A angegebenen Weise auf. Die Inverterstufe I zur Kopplung der Gatter G2 und G1 weist eine Verzögerung 36 auf. An den Transfer-Gates TG liegen die Spannungen vint und gnd an, die jeweils ein internes positives Versorgungspotential bzw. eine Bezugsspannung des Verzögerungsregelkreises bezeichnen.

Der Schaltungsblock A1 (vgl. auch in Verbindung mit Figur 2) empfängt das Eingangstaktsignal clock und erzeugt an einem Ausgang das Taktsignal clock/2 mit reduzierter Frequenz. Gemäß der Ausführungsform nach Figur 3A erzeugt der Schaltungsblock A1 weiterhin ein zum Taktsignal clock/2 komplementäres Taktsignal clock/2_b. Der Schaltungsblock A2 empfängt das komplementäre Eingangstaktsignal bclock und erzeugt an einem der Ausgänge das Komplementär-Taktsignal bclock/2 mit reduzierter Frequenz und ein dazu komplementäres Komplementär-Taktsignal bclock/2_b mit reduzierter Frequenz an dem anderen der Ausgänge. Im Signaldiagramm der Figur 3B ist ein beispielhafter Signalverlauf für die Taktsignale clock, clock/2 und clock/2_b gezeigt. Die Taktsignale clock/2 und clock/2_b weisen im vorliegenden Ausführungsbeispiel jeweils die halbe Frequenz zum Taktsignal clock auf. Die Flanken sind jeweils um die Verzögerungszeit δ zu entsprechenden Flanken des Signals clock verzögert.

Im ersten Schaltungsteil wird somit die Frequenz des Eingangstaktsignals reduziert, im vorliegenden Fall halbiert, wobei die Zeitinformation der steigenden Flanken des Eingangstaktsignals in eine steigende und fallende Flanke des Taktsignals mit reduzierter Frequenz transformiert wird.

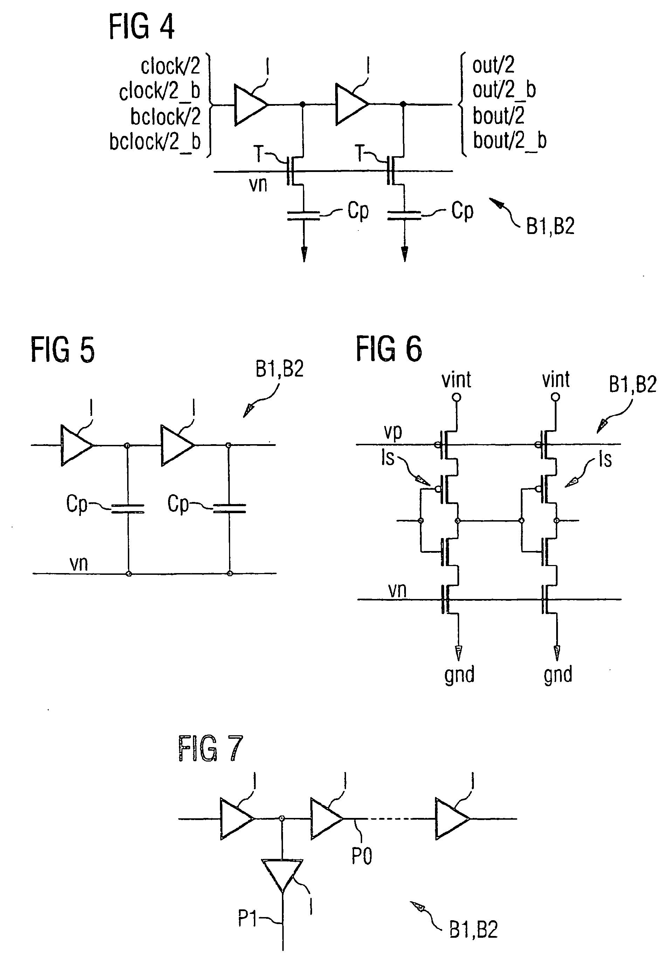

In den Figuren 4 bis 7 sind jeweilige Ausführungsformen von Verzögerungsketten in ihrer grundlegenden Form zur Verwendung in einer Verzögerungseinrichtung des Verzögerungsregelkreises gemäß Figur 2 näher dargestellt. Hierbei kann eine Verzögerungskette zur Realisierung jeweils eines der Schaltungsblöcke B1, B2 verwendet werden.

Die Verzögerungskette gemäß Figur 4 weist in Reihe geschaltete Inverterstufen I auf, wobei zwischen den Inverterstufen I an jeweiligen Verbindungsknoten eine Kapazität Cp angeschlossen ist. Ein erster Anschluß der jeweiligen Kapazität Cp ist über einen steuerbaren Transistor T mit dem jeweiligen Verbindungsknoten verbunden, wobei der Transistor T vom Steuersignal vn der Steuerungseinrichtung 4 steuerbar ist. Ist die Verzögerungskette gemäß Figur 4 im Schaltungsblock B1 vorgesehen, empfängt die linke Inverterstufe I das Taktsignal clock/2 mit reduzierter Frequenz. Der rechte Inverter I gibt entsprechend an seinem Ausgang das verzögerte Taktsignal out/2 mit reduzierter Frequenz aus. Da die Schaltungsblöcke A1 und A2 gemäß der Ausführungsform nach Figur 3 jeweils zwei Ausgangssignale an den Schaltungsteil 2-B weiterleiten, weist dieser vier Verzögerungsketten auf, die jeweils eines der Taktsignale empfangen und ein jeweils verzögertes Taktsignal ausgeben. Entsprechend stehen an den Ausgängen des zweiten Schaltungsteils 2-B neben dem verzögerten Taktsignal out/2 mit reduzierter Frequenz das verzögerte, dazu komplementäre Taktsignal out/2_b mit reduzierter Frequenz, das verzögerte Komplementär-Taktsignal bout/2 und das verzögerte, dazu komplementäre Komplementär-Taktsignal bout/2_b mit reduzierter Frequenz zur Verfügung.

In Figur 5 ist eine weitere Ausführungsform einer Verzögerungskette für den zweiten Schaltungsteil 2-B des Verzögerungsregelkreises gemäß Figur 2 dargestellt. Die Verzögerungskette gemäß Figur 5 weist wiederum in Reihe geschaltete Inverterstufen I auf, wobei zwischen den Inverterstufen an jeweiligen Verbindungsknoten jeweils eine Kapazität Cp angeschlossen ist. Ein erster Anschluß der jeweiligen Kapazität Cp ist mit dem jeweiligen Verbindungsknoten verbunden und ein zweiter Anschluß der Kapazität mit einem Potentialanschluß, wobei das Potential vn am Potentialanschluß von der Steuerungseinrichtung 4 steuerbar ist.

In Figur 6 ist eine weitere Ausführungsform einer Verzögerungskette dargestellt, die zwei in Reihe geschaltete steuerbare Inverterstufen Is aufweist. Die Inverterstufen Is sind über die Steuerpotentiale vn und vp in ihrer Schaltgeschwindigkeit steuerbar und zwischen die Versorgungspotentiale vint und gnd geschaltet.

In Figur 7 ist eine weitere Ausführungsform einer Verzögerungskette dargestellt, die eine verzweigte Anordnung von Inverterstufen I aufweist. Hierbei ist die Verzögerungszeit steuerbar, indem Inverterstufen unterschiedlicher Verzweigungen zu- bzw. abgeschaltet werden. Beispielsweise wird für eine erste Verzögerungszeit eine Inverterstufe I des Signalpfades P0 zugeschaltet, für eine zweite Verzögerungszeit hingegen die Inverterstufe I des Signalpfades P1.

Den Ausführungsformen einer Verzögerungskette gemäß Figuren 4 bis 6 ist gemeinsam, daß sie bezüglich steigender und fallender Flanken eines zu verzögernden Taktsignals symmetrisch aufgebaut sind, so daß die steigenden und fallenden Flanken eines zu verzögernden Taktsignals näherungsweise gleich verzögert werden. Dagegen ist die Verzögerungskette gemäß Ausführungsform nach Figur 7 unsymmetrisch aufgebaut.

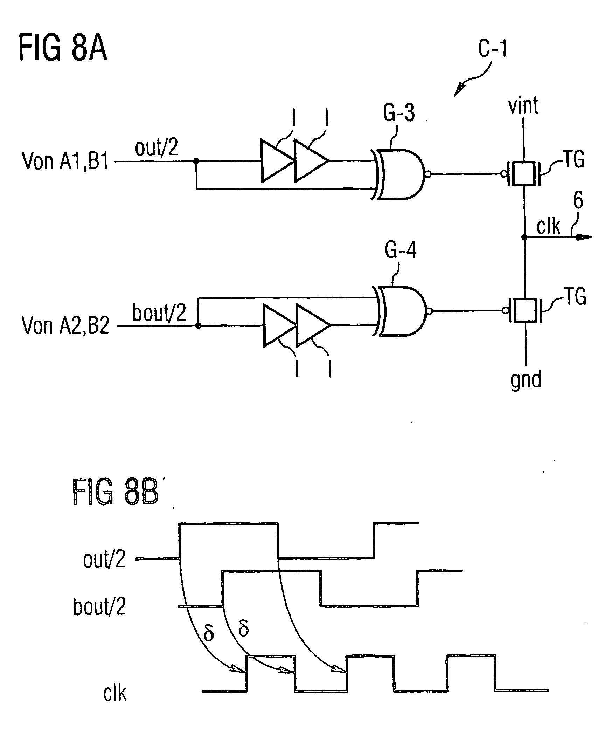

In Figur 8 wird eine erste Ausführungsform eines dritten Schaltungsteils einer Verzögerungseinrichtung des Verzögerungsregelkreises gemäß Figur 2 mit einem zugehörigen Signaldiagramm gezeigt. Hierbei wird nur das verzögerte Taktsignal out/2 mit reduzierter Frequenz und das verzögerte Komplementär-Taktsignal bout/2 mit reduzierter Frequenz zur Erzeugung des Ausgangstaktsignals clk verwendet. Der Schaltungsblock C-1 gemäß Figur 8A weist eine Verschaltung aus Inverterstufen I, aus EXNOR-Gattern G-3, G-4 und aus Transfer-Gates TG in der in Figur 8A angegebenen Weise auf.

Gemäß dem Signaldiagramm aus Figur 8B wird deutlich, daß durch den Schaltungsblock C-1 zur Realisierung des dritten Schaltungsteils 2-C gemäß Figur 2 die steigenden Flanken des Ausgangstaktsignals clk aus den steigenden und fallenden Flanken des verzögerten Taktsignals out/2 mit reduzierter Frequenz erzeugt werden. Entsprechend werden die fallenden Flanken des Ausgangstaktsignals clk aus den steigenden und fallenden Flanken des verzögerten Komplementär-Taktsignals bout/2 mit reduzierter Frequenz erzeugt. Das Ausgangstaktsignal clk weist die Frequenz des Eingangstaktsignals clock auf, im vorliegenden Beispiel also die doppelte Frequenz der Taktsignale out/2 bzw. bout/2.

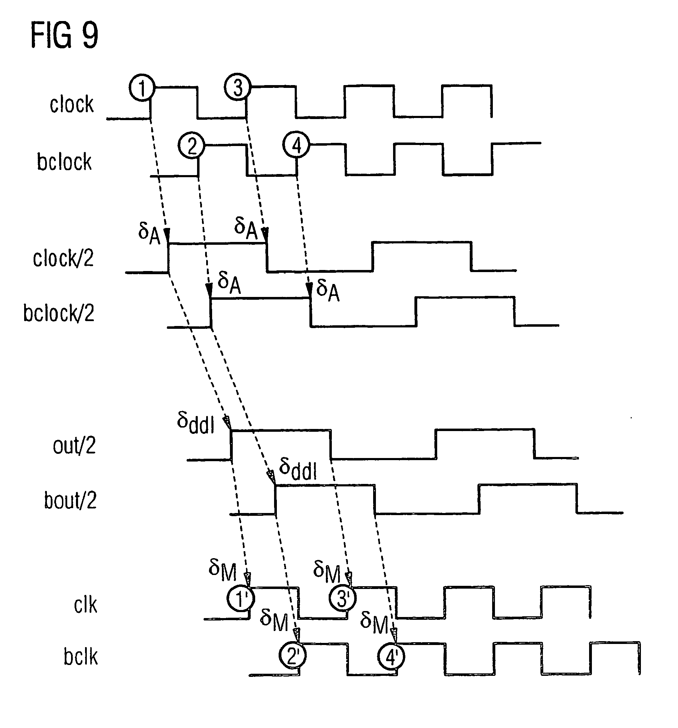

In Figur 9 ist ein Signaldiagramm von Signalen entsprechend einer Ausführungsform eines Verzögerungsregelkreises gezeigt, dessen Verzögerungseinrichtung lediglich zwei Verzögerungsketten im zweiten Schaltungsteil aufweist. Ein Schaltungsblock A1 erzeugt das Taktsignal clock/2 mit reduzierter Frequenz, ein Schaltungsblock A2 erzeugt das Komplementär-Taktsignal bclock/2 mit reduzierter Frequenz (vgl. auch Figur 3). An einer ersten Verzögerungskette ist das gegenüber clock/2 verzögerte Taktsignal out/2 mit reduzierter Frequenz abgreifbar, an einer zweiten Verzögerungskette das gegenüber bclock/2 verzögerte Komplementär-Taktsignal bout/2 mit reduzierter Frequenz. Hierbei weisen die Verzögerungsketten die Verzögerungszeit δd11 auf. Die Taktsignale clock/2 bzw. bclock/2 werden mit der Verzögerungszeit δA erzeugt. Die steigenden Flanken des Ausgangstaktsignals clk werden aus den steigenden und fallenden Flanken des verzögerten Taktsignals out/2 mit reduzierter Frequenz erzeugt und die fallenden Flanken des Ausgangstaktsignals clk (bzw. die steigenden Flanken des komplementären Ausgangstaktsignals bclk) aus den steigenden und fallenden Flanken des verzögerten Komplementär-Taktsignals bout/2 mit reduzierter Frequenz. Dies geschieht jeweils mit Verzögerungszeit δM.

Gemäß dieser Ausführungsform kann der Schaltungsteil 2-C vergleichsweise einfach ausgeführt werden (vgl. Figur 8), setzt allerdings voraus, daß die steigenden und fallenden Flanken der Taktsignale in der Verzögerungskette näherungsweise gleich verzögert werden. In Summe erhält man Taktsignale clk, bclk, deren steigende Flanken zu Zeitpunkten (1') bis (4') mit gleicher Verzögerungszeit in Bezug zu den steigenden Flanken der Taktsignale clock, bclock zu den Zeitpunkten (1) bis (4) verzögert sind. Die Verzögerung δA zwischen der steigenden Flanke des Eingangstaktsignals und der steigenden oder fallenden Flanke des Taktsignals mit reduzierter Frequenz wird auf den gleichen festen Wert eingestellt und verändert sich nicht mit der Betriebsfrequenz.

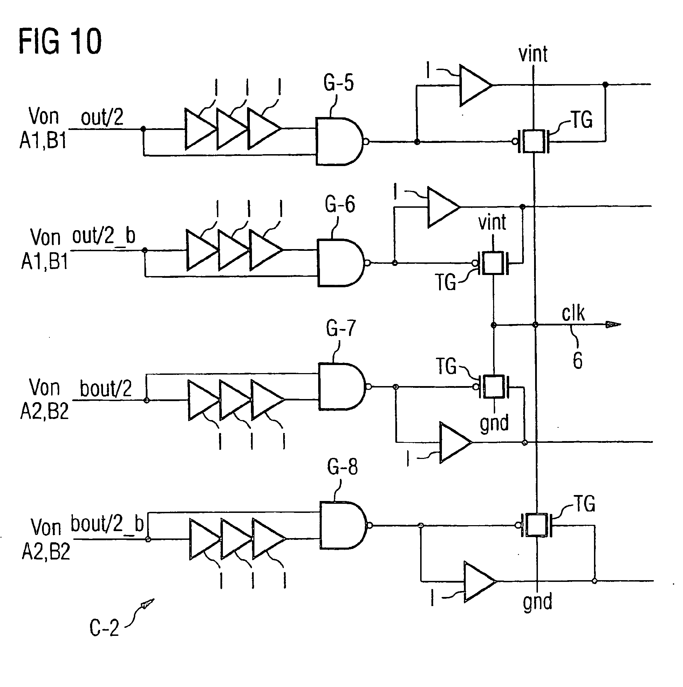

In Figur 10 ist eine zweite Ausführungsform eines dritten Schaltungsteils einer Verzögerungseinrichtung des Verzögerungsregelkreises gemäß Figur 2 gezeigt. Hierbei werden alle ausgegebenen Taktsignale des ersten Schaltungsteils 2-A (vgl. Schaltungsblöcke A1, A2 gemäß Figur 3) zur Rekonstruktion des Ausgangstaktsignals clk verwendet. Der zweite Schaltungsteil 2-B weist in diesem Ausführungsbeispiel vier Verzögerungsketten auf, die jeweils die verzögerten Taktsignale out/2, out/2_b, bout/2 und bout/2_b ausgeben. Der Schaltungsblock C-2 des dritten Schaltungsteils weist die in Figur 10 angegebene Verschaltung aus Inverterstufen I, NAND-Gattern G-5 bis G-8 und Transfer-Gates TG auf.

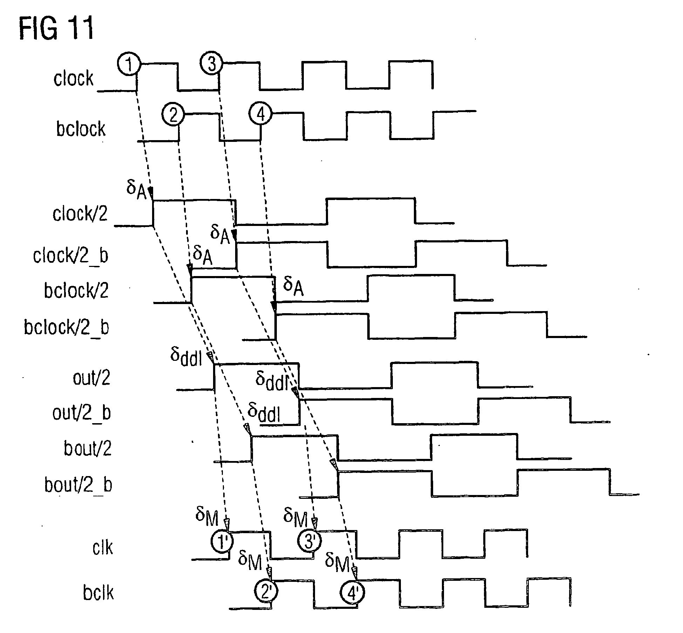

In Figur 11 ist ein zugehöriges Signaldiagramm von Signalen einer entsprechenden Ausführungsform eines Verzögerungsregelkreises gemäß Figur 2 gezeigt. Der Schaltungsblock A1 des ersten Schaltungsteils 2-A erzeugt aus dem Eingangstaktsignal clock das Taktsignal clock/2 und ein dazu komplementäres Taktsignal clock/2_b mit reduzierter Frequenz. Der Schaltungsblock A2 des ersten Schaltungsteils 2-A erzeugt aus dem komplementären Eingangstaktsignal bclock das Komplementär-Taktsignal bclock/2 und ein dazu komplementäres Komplementär-Taktsignal bclock/2_b mit jeweils reduzierter Frequenz. Jeweils eine der Verzögerungsketten des zweiten Schaltungsteils 2-B (jeder der Schaltungsblöcke B1, B2 weist zwei Verzögerungsketten auf) leitet eines dieser Signale an den dritten Schaltungsteil 2-C weiter. Dieser ist insbesondere in Form des Schaltungsblocks C-2 gemäß Figur 10 ausgeführt und erzeugt aus den steigenden Flanken des verzögerten Taktsignals out/2 und den steigenden Flanken des verzögerten komplementären Taktsignals out/2_b die steigenden Flanken des Ausgangstaktsignals clk. Entsprechend werden die fallenden Flanken des Ausgangstaktsignals clk (bzw. die steigenden Flanken des komplementären Ausgangstaktsignals bclk) aus den steigenden Flanken des verzögerten Komplementär-Taktsignals bout/2 und den steigenden Flanken des verzögerten komplementären Komplementär-Taktsignals bout/2_b erzeugt. Diese Ausführungsform hat den Vorteil, daß zur Rekonstruktion des Ausgangstaktsignals nur die steigenden Flanken von aus der jeweiligen Verzögerungskette ausgegebenen Taktsignalen maßgeblich sind. Es kann entsprechend eine bezüglich steigender und fallender Flanken unsymmetrische Verzögerungskette verwendet werden.

### Bezugszeichenliste

- 1: Verzögerungsregelkreis
- 2: Verzögerungseinrichtung
- 3: Verzögerungselement
- 4: Steuerungseinrichtung mit Phasendetektor
- 5: Eingangsanschluß
- 6: Ausgangsanschluß
- 2-A: erster Schaltungsteil
- 2-B: zweiter Schaltungsteil
- 2-C: dritter Schaltungsteil
- 10: Verzögerungskette
- 1-1 bis 1-n: Inverterstufe
- 2-1 bis 2-n: Kapazität
- 3-1 bis 3-n: Transistor
- K1, K2: Verbindungsknoten
- IN: Eingangsanschluß
- OT: Ausgangsanschluß
- Trcv: Verzögerungszeit
- Tocd: Verzögerungszeit
- clock: Eingangstaktsignal
- bclock: komplementäres Eingangstaktsignal
- clk: Ausgangstaktsignal
- bclk: komplementäres Ausgangstaktsignal
- A1, A2: Schaltungsblock
- B1, B2: Schaltungsblock
- C: Schaltungsblock
- vn, vp: Steuersignal
- I: Inverterstufe
- TG: Transfer-Gate
- G-1 bis G-8: Gatter
- vint: Versorgungsspannung
- gnd: Bezugsspannung
- clock/2: Taktsignal mit reduzierter Frequenz
- clock/2_b: komplementäres Taktsignal mit reduzierter Frequenz
- bclock/2: Komplementär-Taktsignal mit reduzierter Frequenz
- bclock/2_b: komplementäres Komplementär-Taktsignal mit reduzierter Frequenz
- out/2: verzögertes Taktsignal mit reduzierter Frequenz
- out/2_b: verzögertes komplementäres Taktsignal mit reduzierter Frequenz
- bout/2: verzögertes Komplementär-Taktsignal mit reduzierter Frequenz
- bout/2_b: verzögertes komplementäres Komplementär-Taktsignal mit reduzierter Frequenz
- Cp: Kapazität
- Is: steuerbare Inverterstufe
- PO, P1: Signalpfad
- δ: Verzögerungszeit
- δA: Verzögerungszeit
- δd11: Verzögerungszeit
- δM: Verzögerungszeit
- (1) bis (4): Zeitpunkt
- (1') bis (4'): Zeitpunkt

## Patentansprüche

1. Verzögerungsregelkreis, umfassend:
- einen Eingangsanschluß (5) für ein zu verzögerndes Eingangstaktsignal (clock) und einen Ausgangsanschluß (6) zum Abgriff eines verzögerten Ausgangstaktsignals (clk),
- eine Verzögerungseinrichtung (2) mit steuerbarer Verzögerungszeit, die einen ersten Schaltungsteil (2-A), einen dem ersten Schaltungsteil nachgeschalteten zweiten Schaltungsteil (2-B) und einen dem zweiten Schaltungsteil nachgeschalteten dritten Schaltungsteil (2-C) aufweist, wobei die Verzögerungseinrichtung in Reihe zwischen den Eingangsanschluß (5) und den Ausgangsanschluß (6) geschaltet ist,
- eine Steuerungseinrichtung (4) zur Bereitstellung eines der Verzögerungseinrichtung (2) zuführbaren Steuersignals (vn, vp) in Abhängigkeit von einer Phasendifferenz zwischen dem zu verzögernden und dem verzögerten Taktsignal (clock, clk),
- bei dem der erste Schaltungsteil (2-A) das Eingangstaktsignal (clock) empfängt, eine Frequenz des Eingangstaktsignals reduziert und ein Taktsignal mit reduzierter Frequenz (clock/2) ausgibt,
- bei dem der zweite Schaltungsteil (2-B) das Taktsignal mit reduzierter Frequenz (clock/2) mit steuerbarer Verzögerungszeit verzögert an den dritten Schaltungsteil (2-C) weiterleitet, **dadurch gekennzeichnet, dass**
- der dritte Schaltungsteil (2-C) aus dem verzögerten Taktsignal mit reduzierter Frequenz (out/2) das Ausgangstaktsignal (clk) erzeugt, welches die Frequenz des Eingangstaktsignals (clock) aufweist.

2. Verzögerungsregelkreis nach Anspruch 1,
**dadurch gekennzeichnet, daß**
- der Eingangsanschluß (5) das zu verzögernde Eingangstaktsignal (clock) und ein dazu komplementäres Eingangstaktsignal (bclock) empfängt,
- der erste Schaltungsteil (2-A, A1, A2) aus dem Eingangstaktsignal (clock) das Taktsignal mit reduzierter Frequenz (clock/2) und aus dem komplementären Eingangstaktsignal (bclock) ein Komplementär-Taktsignal mit reduzierter Frequenz (bclock/2) erzeugt,
- der zweite Schaltungsteil (2-B) zwei Verzögerungsketten (B1, B2) aufweist, wobei eine der Verzögerungsketten (B1) das Taktsignal mit reduzierter Frequenz (clock/2) und die andere der Verzögerungsketten (B2) das Komplementär-Taktsignal mit reduzierter Frequenz (bclock/2) jeweils mit steuerbarer Verzögerungszeit verzögert an den dritten Schaltungsteil weiterleiten,
- der dritte Schaltungsteil (2-C, C-1) aus dem verzögerten Taktsignal mit reduzierter Frequenz (out/2) und dem verzögerten Komplementär-Taktsignal mit reduzierter Frequenz (bout/2) das Ausgangstaktsignal (clk) erzeugt.

3. Verzögerungsregelkreis nach Anspruch 2,
**dadurch gekennzeichnet, daß**
der dritte Schaltungsteil (C-1) die steigenden Flanken des Ausgangstaktsignals (clk) aus den steigenden und fallenden Flanken des verzögerten Taktsignals mit reduzierter Frequenz (out/2) erzeugt und die fallenden Flanken des Ausgangstaktsignals (clk) aus den steigenden und fallenden Flanken des verzögerten Komplementär-Taktsignals mit reduzierter Frequenz (bout/2) erzeugt.

4. Verzögerungsregelkreis nach Anspruch 2 oder 3,
**dadurch gekennzeichnet, daß**
der zweite Schaltungsteil (2-B) derart beschaffen ist, daß die Verzögerungszeit in Bezug auf das Taktsignal mit reduzierter Frequenz (clock/2) und das Komplementär-Taktsignal (bclock/2) mit reduzierter Frequenz näherungsweise gleich ist.

5. Verzögerungsregelkreis nach Anspruch 4,
**dadurch gekennzeichnet, daß**
der zweite Schaltungsteil (2-B) derart beschaffen ist, daß die steigenden und fallenden Flanken des Taktsignals mit reduzierter Frequenz (clock/2) und des Komplementär-Taktsignals mit reduzierter Frequenz (bclock/2) näherungsweise gleich verzögert werden.

6. Verzögerungsregelkreis nach einem der Ansprüche 1 bis 5,
**dadurch gekennzeichnet, daß**
- der Eingangsanschluß (5) das zu verzögernde Eingangstaktsignal (clock) und ein dazu komplementäres Eingangstaktsignal (bclock) empfängt,
- der erste Schaltungsteil (2-A, A1, A2) aus dem Eingangstaktsignal (clock) das Taktsignal mit reduzierter Frequenz (clock/2) und ein dazu komplementäres Taktsignal mit reduzierter Frequenz (clock/2_b) erzeugt, und aus dem komplementären Eingangstaktsignal (bclock) ein Komplementär-Taktsignal mit reduzierter Frequenz (bclock/2) und ein dazu komplementäres Komplementär-Taktsignal mit reduzierter Frequenz (bclock/2_b) erzeugt,
- der zweite Schaltungsteil (2-B) vier Verzögerungsketten (B1, B2) aufweist, wobei jeweils eine der Verzögerungsketten das Taktsignal mit reduzierter Frequenz (clock/2), das komplementäre Taktsignal mit reduzierter Frequenz (clock/2_b), das Komplementär-Taktsignal mit reduzierter Frequenz (bclock/2) und das komplementäre Komplementär-Taktsignal mit reduzierter Frequenz (bclock/2_b) verzögert jeweils mit steuerbarer Verzögerungszeit an den dritten Schaltungsteil weiterleitet,
- der dritte Schaltungsteil (2-C, C-2) aus dem verzögerten Taktsignal mit reduzierter Frequenz (out/2), dem verzögerten komplementären Taktsignal mit reduzierter Frequenz (out/2_b), dem verzögerten Komplementär-Taktsignal mit reduzierter Frequenz (bout/2) und dem verzögerten komplementären Komplementär-Taktsignal mit reduzierter Frequenz (bout/2_b) das Ausgangstaktsignal erzeugt.

7. Verzögerungsregelkreis nach Anspruch 6,
**dadurch gekennzeichnet, daß**
- der dritte Schaltungsteil (C-2) die steigenden Flanken des Ausgangstaktsignals (clk) aus den steigenden Flanken des verzögerten Taktsignals mit reduzierter Frequenz (out/2) und den steigenden Flanken des verzögerten komplementären Taktsignals mit reduzierter Frequenz (out/2_b) erzeugt,
- der dritte Schaltungsteil (C-2) die fallenden Flanken des Ausgangstaktsignals (clk) aus den steigenden Flanken des verzögerten Komplementär-Taktsignals mit reduzierter Frequenz (bout/2) und den steigenden Flanken des verzögerten komplementären Komplementär-Taktsignals mit reduzierter Frequenz (bout/2_b) erzeugt.

8. Verzögerungsregelkreis nach einem der Ansprüche 1 bis 7,
**dadurch gekennzeichnet, daß**
der zweite Schaltungsteil (2-B) eine Verzögerungskette (B1, B2) mit in Reihe geschalteten Inverterstufen (I) aufweist, wobei zwischen den Inverterstufen an jeweiligen Verbindungsknoten jeweils eine Kapazität (Cp) angeschlossen ist.

9. Verzögerungsregelkreis nach Anspruch 8,
**dadurch gekennzeichnet, daß**
ein erster Anschluß der jeweiligen Kapazität (Cp) über einen steuerbaren Transistor (T) mit dem jeweiligen Verbindungsknoten verbunden ist, wobei der Transistor vom Steuersignal (vn) der Steuerungseinrichtung (4) steuerbar ist.

10. Verzögerungsregelkreis nach Anspruch 8,
**dadurch gekennzeichnet, daß**
ein erster Anschluß der jeweiligen Kapazität (Cp) mit dem jeweiligen Verbindungsknoten und ein zweiter Anschluß der jeweiligen Kapazität (Cp) mit einem Potentialanschluß verbunden ist, wobei ein Potential (vn) am Potentialanschluß vom Steuersignal (vn) der Steuerungseinrichtung (4) steuerbar ist.

## Claims

1. Delay locked loop comprising:
- an input connection (5) for an input clock signal (clock) which is to be delayed and an output connection (6) for tapping off an output clock signal (clk) which has been delayed,
- a delay device (2) which has a controllable delay time and has a first circuit part (2-A), a second circuit part (2-B) which is connected downstream of the first circuit part and a third circuit part (2-C) which is connected downstream of the second circuit part, the delay device being connected in series between the input connection (5) and the output connection (6),
- a control device (4) for providing a control signal (vn, vp) - which can be supplied to the delay device (2) - on the basis of a phase difference between the clock signal (clock) which is to be delayed and the clock signal (clk) which has been delayed,
- in which the first circuit part (2-A) receives the input clock signal (clock), reduces the frequency of the input clock signal and outputs a clock signal which is at a reduced frequency (clock/2),
- in which the second circuit part (2-B) forwards the clock signal which is at a reduced frequency (clock/2) to the third circuit part (2-C) in such a manner that said clock signal has been delayed by a controllable delay time, **characterized in that**
- the third circuit part (2-C) uses the delayed clock signal which is at a reduced frequency (out/2) to generate the output clock signal (clk) which is at the frequency of the input clock signal (clock).

2. Delay locked loop according to Claim 1,
**characterized in that**
- the input connection (5) receives the input clock signal (clock) which is to be delayed and an input clock signal (bclock) which is complementary to the latter,
- the first circuit part (2-A, A1, A2) uses the input clock signal (clock) to generate the clock signal which is at a reduced frequency (clock/2) and uses the complementary input clock signal (bclock) to generate a complementary clock signal which is at a reduced frequency (bclock/2),
- the second circuit part (2-B) has two delay chains (B1, B2), one of the delay chains (B1) forwarding the clock signal which is at a reduced frequency (clock/2), and the other of the delay chains (B2) forwarding the complementary clock signal which is at a reduced frequency (bclock/2), to the third circuit part in such a manner that each of said signals has been delayed by a controllable delay time,
- the third circuit part (2-C, C-1) uses the delayed clock signal which is at a reduced frequency (out/2) and the delayed complementary clock signal which is at a reduced frequency (bout/2) to generate the output clock signal (clk).

3. Delay locked loop according to Claim 2,
**characterized in that**
the third circuit part (C-1) generates the rising edges of the output clock signal (clk) from the rising and falling edges of the delayed clock signal which is at a reduced frequency (out/2) and generates the falling edges of the output clock signal (clk) from the rising and falling edges of the delayed complementary clock signal which is at a reduced frequency (bout/2).

4. Delay locked loop according to Claim 2 or 3,
**characterized in that**
the second circuit part (2-B) is configured such that the delay time is approximately the same for the clock signal which is at a reduced frequency (clock/2) and the complementary clock signal (bclock/2) which is at a reduced frequency.

5. Delay locked loop according to Claim 4,
**characterized in that**
the second circuit part (2-B) is configured such that the rising and falling edges of the clock signal which is at a reduced frequency (clock/2) and of the complementary clock signal which is at a reduced frequency (bclock/2) are delayed to approximately the same extent.

6. Delay locked loop according to one of Claims 1 to 5,
**characterized in that**
- the input connection (5) receives the input clock signal (clock) which is to be delayed and an input clock signal (bclock) which is complementary to the latter,
- the first circuit part (2-A, A1, A2) uses the input clock signal (clock) to generate the clock signal which is at a reduced frequency (clock/2) and a clock signal which is at a reduced frequency (clock/2_b) and is complementary to the latter and uses the complementary input clock signal (bclock) to generate a complementary clock. signal which is at a reduced frequency (bclock/2) and a complementary clock signal which is at a reduced frequency (bclock/2_b) and is complementary to the latter,
- the second circuit part (2-B) has four delay chains (B1, B2), a respective one of the delay chains forwarding the clock signal which is at a reduced frequency (clock/2), the complementary clock signal which is at a reduced frequency (clock/2_b), the complementary clock signal which is at a reduced frequency (bclock/2), and the complementary clock signal which is complementary and is at a reduced frequency (bclock/2_b) to the third circuit part in such a manner that each of said signals has been delayed by a controllable delay time,
- the third circuit part (2-C, C-2) uses the delayed clock signal which is at a reduced frequency (out/2), the delayed complementary clock signal which is at a reduced frequency (out/2_b), the delayed complementary clock signal which is at a reduced frequency (bout/2) and the delayed complementary clock signal which is complementary and is at a reduced frequency (bout/2_b) to generate the output clock signal.

7. Delay locked loop according to Claim 6,
**characterized in that**
- the third circuit part (C-2) generates the rising edges of the output clock signal (clk) from the rising edges of the delayed clock signal which is at a reduced frequency (out/2) and the rising edges of the delayed complementary clock signal which is at a reduced frequency (out/2_b),
- the third circuit part (C-2) generates the falling edges of the output clock signal (clk) from the rising edges of the delayed complementary clock signal which is at a reduced frequency (bout/2) and the rising edges of the delayed complementary clock signal which is complementary and is at a reduced frequency (bout/2_b).

8. Delay locked loop according to one of Claims 1 to 7,
**characterized in that**
the second circuit part (2-B) has a delay chain (B1, B2) having inverter stages (I) which are connected in series, a respective capacitance (Cp) being connected to respective connecting nodes between the inverter stages.

9. Delay locked loop according to Claim 8,
**characterized in that**
a first connection of the respective capacitance (Cp) is connected to the respective connecting node via a controllable transistor (T), the transistor being able to be controlled by the control signal (vn) from the control device (4).

10. Delay locked loop according to Claim 8,
**characterized in that**
a first connection of the respective capacitance (Cp) is connected to the respective connecting node, and a second connection of the respective capacitance (Cp) is connected to a potential connection, a potential (vn) at the potential connection being able to be controlled by the control signal (vn) from the control device (4).

## Revendications

1. Circuit de régulation de temporisation comprenant :
- une borne (5) d'entrée pour un signal (clock) d'horloge d'entrée temporisateur et une borne (6) de sortie pour le prélèvement d'un signal (clk) d'horloge de sortie temporisé,
- un dispositif (2) de temporisation ayant un temps de temporisation pouvant être commandé et comportant une première partie (2-A) de circuit, une deuxième partie (2-B) de circuit montée en aval de la première partie de circuit et une troisième partie (2-C) de circuit montée en aval de la deuxième partie de circuit, le dispositif de temporisation étant monté en série entre la borne (5) d'entrée et la borne (6) de sortie,
- un dispositif (4) de commande pour mettre à disposition un signal (vn, vp) de commande pouvant être envoyé au dispositif (2) de temporisation en fonction d'une différence de phase entre le signal (clock, clk) d'horloge temporisateur et temporisé,
- dans lequel la première partie (2-A) de circuit reçoit le signal (clock) d'horloge d'entrée, réduit une fréquence du signal d'horloge d'entrée et émet un signal d'horloge de fréquence (clock/2) réduite,
- dans lequel la deuxième partie (2-B) de circuit achemine le signal d'horloge de fréquence (clock/2) réduite, retardé d'une durée de temporisation pouvant être commandée, à la troisième partie (2-C) de circuit, **caractérisé en ce que**
- la troisième partie (2-C) de circuit produit, à partir du signal d'horloge temporisé de fréquence (out/2) réduite, le signal (clk) d'horloge de sortie, qui a la fréquence du signal (clock) d'horloge d'entrée.

2. Circuit de régulation de temporisation suivant la revendication 1,
**caractérisé en ce que**
- la borne (5) d'entrée reçoit le signal (clock) d'horloge d'entrée à temporiser et un signal (bclock) d'horloge d'entrée complémentaire de celui-ci,
- la première partie (2-A, A1, A2) de circuit produit, à partir du signal (clock) d'horloge d'entrée, le signal d'horloge de fréquence (clock/2) réduite et, à partir du signal (bclock) d'horloge d'entrée complémentaire, un signal d'horloge complémentaire de fréquence (bclock/2) réduite,
- la deuxième partie (2-B) de circuit a deux chaînes (B1, B2) de temporisation, l'une des chaînes (B1) de temporisation acheminant le signal d'horloge de fréquence (clock/2) réduite et l'autre chaîne (B2) de temporisation le signal d'horloge complémentaire de fréquence (bclock/2) réduite, respectivement retardé d'une durée de temporisation pouvant être commandée, à la troisième partie de circuit,
- la troisième partie (2-C, C-1) de circuit produisant, à partir du signal d'horloge temporisé de fréquence (out/2) réduite et du signal d'horloge complémentaire temporisé de fréquence (bout/2) réduite, le signal (clk) d'horloge de sortie.

3. Circuit de régulation de temporisation suivant la revendication 2,
**caractérisé en ce que** la troisième partie (C-1) de circuit produit les fronts montants du signal (clk) d'horloge de sortie à partir des fronts montants et descendants du signal d'horloge temporisé de fréquence (out/2) réduite et produit les fronts descendants du signal (clk) d'horloge de sortie à partir des fronts montants et descendants du signal d'horloge complémentaire temporisé de fréquence (bout/2) réduite.

4. Circuit de régulation de temporisation suivant la revendication 2 ou 3,
**caractérisé en ce que** la deuxième partie (2-B) de circuit est telle que le temps de temporisation concernant le signal d'horloge de fréquence (clock/2) réduite et le signal (bclock/2) d'horloge complémentaire de fréquence réduite est à peu près le même.

5. Circuit de régulation de temporisation suivant la revendication 4,
**caractérisé en ce que** la deuxième partie (2-B) de circuit est telle que les fronts montants et descendants du signal d'horloge de fréquence (clock/2) réduit et du signal d'horloge complémentaire de fréquence (bclock/2) réduite sont temporisés à peu près de même.

6. Circuit de régulation de temporisation suivant l'une des revendication 1 à 5,
**caractérisé en ce que**
- la borne (5) d'entrée reçoit le signal (clock) d'horloge d'entrée temporisé et un signal (bclock) d'horloge d'entrée complémentaire,
- la première partie (2-A, A1, A2) de circuit produit, à partir du signal (clock) d'horloge d'entrée, le signal d'horloge de fréquence (clock/2) réduite et un signal d'horloge qui en est complémentaire et de fréquence (clock/2_b) réduite et à partir du signal (bclock) d'horloge d'entrée complémentaire un signal d'horloge complémentaire, de fréquence (bclock/2) réduite et un signal d'horloge complémentaire qui en est complémentaire de fréquence (bclock/2_b) réduite,
- la deuxième partie (2-B) de circuit a quatre chaînes (B1 , B2) de temporisation, respectivement l'une des chaînes de temporisation acheminant le signal d'horloge de fréquence (clock/2) réduite, le signal d'horloge complémentaire de fréquence (clock/2_b) réduite, le signal d'horloge complémentaire de fréquence (bclock/2) réduite et le signal d'horloge complémentaire de fréquence (bclock/2_b) réduite, retardés respectivement du temps de temporisation pouvant être commandé, à la troisième partie de circuit,
- la troisième partie (2-C, C-2) de circuit produit, à partir du signal d'horloge temporisé de fréquence (out/2) réduite, du signal d'horloge complémentaire temporisé de fréquence (out/2_b) réduite, du signal d'horloge complémentaire temporisé de fréquence (bout/2) réduite et du signal d'horloge complémentaire temporisé de fréquence (bout/2_b) réduite, le signal d'horloge de sortie.

7. Circuit de régulation de temporisation suivant la revendication 6,
**caractérisé en ce que**
- la troisième partie (C-2) de circuit produit les fronts montants du signal (clk) d'horloge de sortie à partir des fronts montants du signal d'horloge temporisé de fréquence (out/2) réduite et des fronts montants du signal d'horloge complémentaire temporisé de fréquence (out/2_b) réduite,
- la troisième partie (C-2) de circuit produit les fronts descendants du signal (clk) d'horloge de sortie à partir des fronts montants du signal d'horloge complémentaire temporisé de fréquence (bout/2) réduite et des fronts montants du signal d'horloge complémentaire temporisé de fréquence (bout/2_b) réduite.

8. Circuit de régulation de temporisation suivant l'une des revendications 1 à 7,
**caractérisé en ce que** la deuxième partie (2-B) de circuit a une chaîne (B1, B2) de temporisation ayant des étages (I) inverseur montés en série, une capacité (Cp) étant raccordée respectivement entre les étages d'inverseur sur chaque noeud de liaison.

9. Circuit de régulation de temporisation suivant la revendication 8,
**caractérisé en ce que**
une première borne de la capacité (Cp) respective est reliée au noeud respectif de liaison par un transistor (T) pouvant être commandé, le transistor pouvant être commandé par un signal (vn) de commande du dispositif (4) de commande.

10. Circuit de régulation de temporisation suivant la revendication 8,
**caractérisé en ce que**
une première borne dont la capacité (Cp) respective est reliée au noeud respectif de liaison et une deuxième borne dont la capacité (Cp) respective a une borne de potentiel, un potentiel (vn) sur la borne de potentiel pouvant être commandé par le signal (vn) de commande du dispositif (4) de commande.
